(19)

Europäisches
Patentamt

European
Patent Office

Office européen
des brevets

(11) **EP 4 545 985 A1**

(12) **EUROPEAN PATENT APPLICATION**
published in accordance with Art. 153(4) EPC

(43) Date of publication:
**30.04.2025 Bulletin 2025/18**

(21) Application number: **22953796.4**

(22) Date of filing: **28.09.2022**

(51) International Patent Classification (IPC):
***G01R 31/34*** (2020.01)     ***G01R 19/00*** (2006.01)
***G01J 5/48*** (2022.01)

(86) International application number:
**PCT/CN2022/122323**

(87) International publication number:
**WO 2024/027003 (08.02.2024 Gazette 2024/06)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **01.08.2022 CN 202210918108**

(71) Applicants:
• **China Nuclear Power Operations Co., Ltd
Shenzhen, Guangdong 518000 (CN)**

• **China General Nuclear Power Corporation
Shenzhen, Guangdong 518028 (CN)**
• **CGN Power Co., Ltd.
Shenzen, Guangdong 518028 (CN)**

(72) Inventor: **WANG, Jiantao
Shenzhen, Guangdong 518000 (CN)**

(74) Representative: **Westphal, Mussgnug & Partner,
Patentanwälte mbB
Werinherstraße 79
81541 München (DE)**

(54) **GENERATOR IRON CORE FAULT DETECTION METHOD AND SYSTEM**

(57)     Disclosed in the present invention are a generator iron core fault detection method and system, for determining whether a fault is present at a suspected fault point of a generator iron core. The method comprises: performing local magnetic circuit setting on a suspected fault point, and building a test magnetic circuit; performing excitation processing on the test magnetic circuit, to make the test magnetic circuit enter a predetermined saturated state for a preset duration; collecting thermal imaging information of the test magnetic circuit, and generating a fault determination result according to the thermal imaging information. Compared with a conventional iron loss method, implementing the present invention can greatly reduce the power required by a test power supply, which can be easily met in a nuclear power plant, without the need to transport a large quantity of heavy test devices. Moreover, the method is simple and efficient, whether an iron core has a fault point can be accurately determined, and the iron loss test duration, workload and cost are effectively reduced.

FIG.1

## Description

### TECHNICAL FIELD

This invention relates to the technical field of electrical maintenance, and in particular to a generator iron core fault detection method and system.

### DESCRIPTION OF RELATED ART

The stator core is an important component of large generators. Generally, it is assembled by hundreds of thousands of sector-shaped silicon steel sheets with a thickness of 0.35 mm or 0.5 mm. If the insulation between the core laminations is damaged, under the action of the magnetic field in the operating condition, relatively large eddy current losses will be generated between the laminations, causing local overheating, which may lead to damage to the core and even the stator bars and result in significant losses. Therefore, the insulation diagnosis of core laminations is an important task in generator maintenance.

At present, the main diagnostic methods used in maintenance are the iron loss method and the ELCID (Electromagnetic Core Imperfection Detector) method.

Wherein, the iron loss method can intuitively reflect the temperature rise at the fault point and evaluate the severity. However, the iron loss test for large generators often requires a power supply at the MVA level, which is difficult to achieve in power plants. It is necessary to transport a large number of test equipment weighing tons and connect dozens of excitation cables. What's more, it may cause further overheating and burnout at the fault point, resulting in secondary damage. Moreover, the diameter of the excitation cables is relatively large, and personnel need to enter the stator bore to measure the temperature. Besides, the iron loss test must be carried out with the rotor removed, which is costly and high-risk.

However, the ELCID method only requires a power supply of several KVA, which can be easily obtained in the factory. It has high sensitivity and will not cause secondary damage to the fault point. The probe used in the ELCID method is very small and can be carried by robots to conduct tests inside the generator without removing the rotor. But the result given by the ELCID method is the quadrature-axis current and cannot directly reflect the temperature rise. Although the ELCID method can accurately detect whether there are fault points in the iron core, the fault points judged by the ELCID method are often inaccurate. Therefore, after the quadrature-axis current exceeds the standard, in order to identify whether the fault points of the iron core can operate safely, it is generally necessary to conduct an additional iron loss test to finally determine whether there is a fault. In practice, there are even cases where the quadrature-axis current exceeds the standard while the iron loss test is qualified, wasting a lot of time, manpower and costs in vain.

## BRIEF SUMMARY OF THE INVENTION

Technical problem

The technical problem to be solved by the present invention lies in that, in view of at least one defect existing in the prior art, a generator iron core fault detection method and system are provided.

Technical Solutions

The technical solution adopted by the present invention to solve its technical problems is as follows: a generator iron core fault detection method is constructed, for determining whether a fault is present at the suspected fault point of a generator iron core, and the method comprises the following steps:

S1. Performing local magnetic circuit setting on a suspected fault point, and building a test magnetic circuit;
S2. Performing excitation processing on the test magnetic circuit, to make the test magnetic circuit enter a predetermined saturated state for a preset duration;
S3. Collecting thermal imaging information of the test magnetic circuit, and generating a fault determination result according to the thermal imaging information.

Preferably, in S1, performing local magnetic circuit setting on a suspected fault point comprising: making the gear teeth on the two adjacent sides of the suspected fault point communicate through a preset magnetic circuit component.

Preferably, the preset magnetic circuit component includes a magnetic circuit component main body and an excitation winding arranged on the magnetic circuit component main body and used for providing magnetic field energy for the test magnetic circuit; the two contact surfaces of the magnetic circuit component main body are respectively attached to the surfaces of the teeth on both sides of the suspected fault point.

Preferably, the magnetic circuit component main body includes a crossbeam, as well as a first side column and a second side column extending outward from both ends of the crossbeam; the effective cross-sectional areas of the crossbeam, the first side column, and the second side column are not less than the tooth tip area of the gear teeth.

Preferably, the step S2 includes: collecting the induced voltage of the suspected fault point, and by adjusting the input voltage of the excitation winding with a preset frequency, making the induced voltage of the suspected fault point be adjusted to be equal to the predetermined saturated voltage of the test magnetic circuit, and maintaining it for a preset duration.

Preferably, the preset magnetic circuit component also includes a measuring coil used for measuring the induced voltage.

Correspondingly, in S2, collecting the induced voltage of the suspected fault point comprising: collecting the measured voltage of the measuring coil, and calculating the induced voltage of the suspected fault point according to the number of turns of the measuring coil and the measured voltage.

The expression of the induced voltage is:$U_s = U_t/N_2$

Wherein, $U_s$ is the induced voltage, $U_t$ is the measured voltage, and $N_2$ is the number of turns of the measuring coil.

Preferably, in S2, the expression of the predetermined saturated voltage is:

$$U_b = B_b * (4.44 * f_b * S_t);$$

wherein, $U_b$ is the predetermined saturated voltage, $B_b$ is the preset saturated magnetic induction intensity of the test magnetic circuit, $f_b$ is the preset frequency, and $S_t$ is the contact area between the magnetic circuit component main body and the gear tooth.

Preferably, in S3, generating a fault determination result according to the thermal imaging information comprising: extracting the temperature features from the thermal imaging information, and judging whether there is an area in the generator iron core part of the test magnetic circuit where the temperature is higher than the fault temperature. If so, it is determined that there is a fault point in the generator iron core; otherwise, it is determined that there is no fault point in the generator iron core.

The present invention also provides a generator iron core fault detection system, which is used for determining whether a fault is present at the suspected fault point of a generator iron core, and comprising:

A preset magnetic circuit component, which is used for building a test magnetic circuit.

An excitation unit, which is used for performing excitation processing on the built test magnetic circuit and making the test magnetic circuit enter a predetermined saturated state for a preset duration;

a thermal imaging acquisition unit, which is used for collecting thermal imaging information of the test magnetic circuit;
a judgment unit, which is used for generating a fault determination result according to the thermal imaging information.

Preferably, the excitation unit includes:

a high-frequency power supply, which is used for providing an input voltage for the excitation winding;
a voltage collector, which is used for measuring the measured voltage of the measuring coil.

an excitation control unit, which is used for controlling the output voltage of the high-frequency power supply according to the measured voltage, so as to make the test magnetic circuit enter a predetermined saturated state and maintain it for a preset duration.

The present invention has at least the following beneficial effects: a generator iron core fault detection method is provided. Firstly, performing local magnetic circuit setting on a suspected fault point, and building a test magnetic circuit. Then, performing excitation processing on the test magnetic circuit, the excitation processing can use a low-power power supply and can also make the test magnetic circuit enter a predetermined saturated state for a preset duration, collecting thermal imaging information of the test magnetic circuit. Finally generating a fault determination result according to the thermal imaging information. Compared with a conventional iron loss method, implementing the present invention can greatly reduce the power required by a test power supply, which can be easily met in a nuclear power plant, without the need to transport a large quantity of heavy test devices. Moreover, the method is simple and efficient, whether an iron core has a fault point can be accurately determined, and the iron loss test duration, workload and cost are effectively reduced.

BRIEF DESCRIPTION OF THE ACCOMPANYING DRAWINGS

The present invention will be further described below in combination with the accompanying drawings and embodiments. In the accompanying drawings:

FIG. 1 is a flowchart of the generator iron core fault detection method provided by the present invention;
FIG. 2 is a structural schematic diagram of the iron core in a certain nuclear power plant;
FIG. 3 is a structural schematic diagram of the preset magnetic circuit component in the present invention;
FIG. 4 is a structural schematic diagram of the generator iron core fault detection system provided by the present invention.

DETAILED DESCRIPTION OF THE INVENTION

In order to have a clearer understanding of the technical features, purposes and effects of the present invention, the specific implementation methods of the present invention will now be described in detail with reference to the accompanying drawings.

It should be noted that the flowchart shown in the accompanying drawings is only for exemplary illustration, and it does not necessarily include all the contents and operations/steps, nor does it have to be executed in the order described. For example, some operations/steps can be decomposed, while some operations/steps can be combined or partially combined. Therefore, the actual execution order may change according to the actual situation.

The block diagrams shown in the accompanying drawings are merely functional entities and do not necessarily have to correspond to physically independent entities. That is to say, these functional entities can be implemented in the form of software, or implemented in one or more hardware modules or integrated circuits, or implemented in different networks and/or processor devices and/or microcontroller devices.

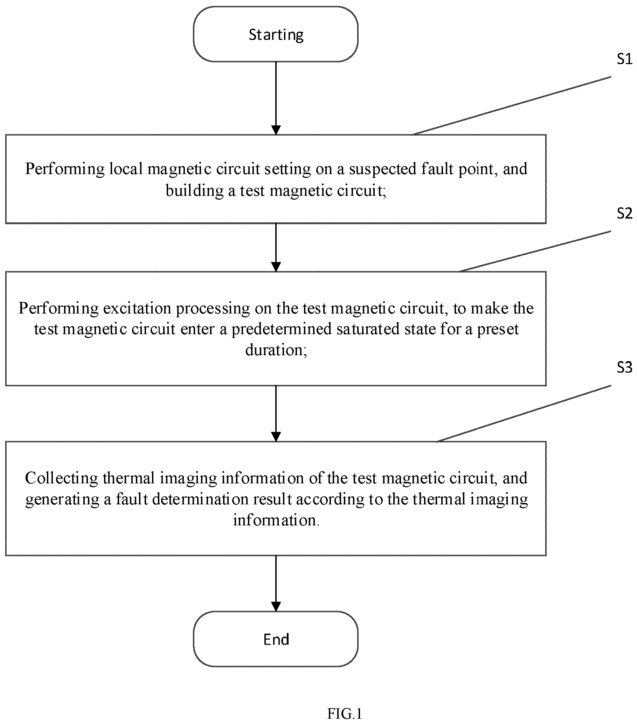

Referring to FIG. 1, the present invention provides a generator iron core fault detection method for determining whether there is a fault at the suspected fault points of a generator iron core. the method includes step S1, step S2 and step S3.

Step S1 includes: performing local magnetic circuit setting on a suspected fault point, and building a test magnetic circuit.

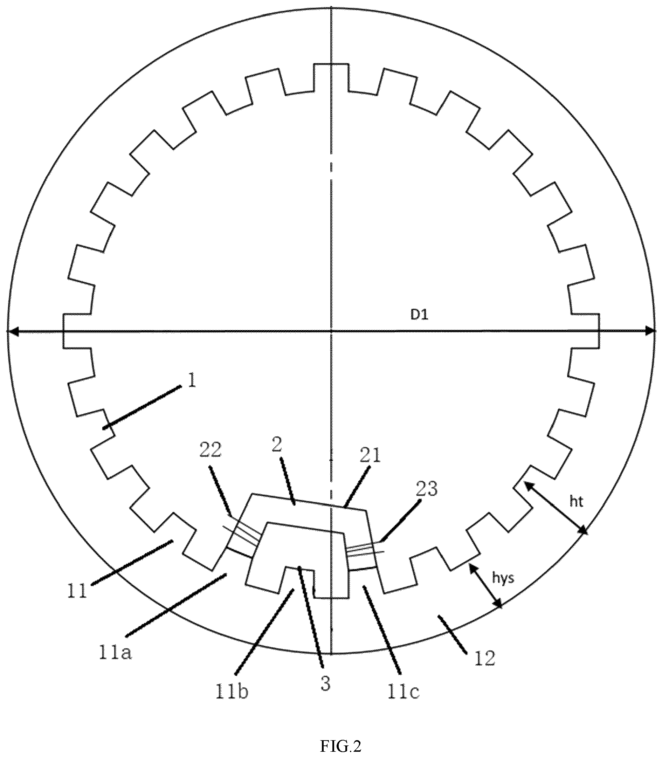

In some embodiments, performing local magnetic circuit setting on a suspected fault point in step S1 includes: making the gear teeth on the two adjacent sides of the suspected fault point communicate through a preset magnetic circuit component 2, and then building the test magnetic circuit. Specifically, as shown in FIG. 2, for example, when the suspected fault point 3 is located on the gear tooth 11b or on the yoke portion in the radial direction of the gear tooth 11b, the preset magnetic circuit component 2 can be arranged on the gear teeth 11a and 11c located on the adjacent two sides of the gear tooth 11b. wherein, the gear tooth refers to each protruding part on the gear used for meshing.

In some embodiments, as shown in FIG. 2, the preset magnetic circuit component 2 includes a magnetic circuit component main body 21 and an excitation winding 22 arranged on the magnetic circuit component main body 21 and used for providing magnetic field energy for the test magnetic circuit. The two contact surfaces of the magnetic circuit component main body 21 are respectively attached to the surfaces of the gear teeth on the two sides of the suspected fault point.

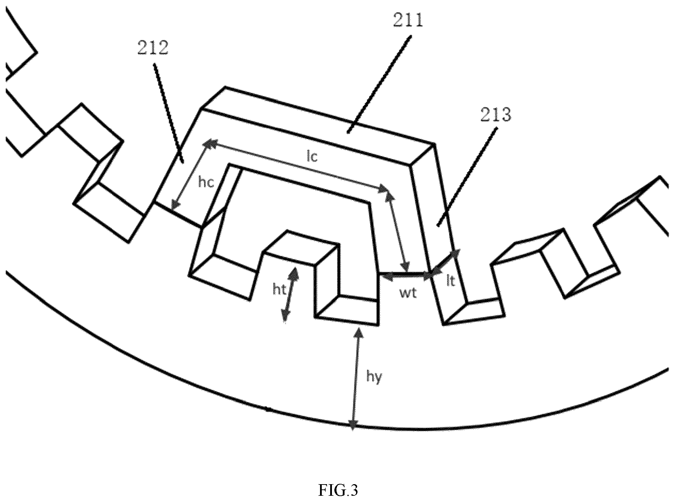

Furthermore, the smaller the effective cross-sectional area of the test magnetic circuit is, the easier and faster it is for the test magnetic circuit to enter a saturated state. However, if the test magnetic circuit saturates too quickly, the iron core will heat up rapidly, which will affect the test accuracy. Moreover, the maximum effective cross-sectional area of the test magnetic circuit is limited by the area of the tooth tip plane of the gear teeth. To avoid the test magnetic circuit entering a saturated state too quickly during the test, in some embodiments, as shown in FIG. 3, the magnetic circuit component main body 21 can be a C-shaped cylinder. The C-shaped cylinder includes a crossbeam 211, and a first side column 212 and a second side column 213 extending outward from the two ends of the crossbeam 211. In addition, the excitation winding 22 can be wound around the first side column 212. wherein, the effective cross-sectional areas of the crossbeam 211, the first side column 212 and the second side column 213 are not less than the tooth tip area of the gear teeth. Preferably, the end faces of the first side column 212 and the second side column 213 are consistent with the tooth tip plane of the gear teeth.

In this embodiment, the function of the preset magnetic circuit component 2 is to build a test magnetic circuit with a relatively small effective cross-sectional area and magnetic circuit, so as to reduce the excitation power required for the iron core fault detection. The specific principle is as follows:

Referring to FIG. 3, after the test magnetic circuit is built by the preset magnetic circuit component 2 in the present invention, the fault point loop is equivalent to a coil with a turn number of 1, and its parameters have the following relationships:

$$\begin{cases} S_1 = U_1 * I_1 \\ U_1 = 4.44 * f_1 * w_t * l_t * B_1 \\ I_1 = 2 * \left( l_c + h_c + h_t + \frac{1}{2} h_y \right) * H_1 \end{cases} \quad (1);$$

Wherein, $S_1$ is the first excitation power, $U_1$ is the first excitation voltage, $f_1$ is the first frequency, $w_t$ is the width of the gear tooth, $l_t$ is the length of the gear tooth, $B_1$ is the first magnetic induction intensity, $I_1$ is the first excitation current, $l_c$ is the iron core width of the magnetic circuit component main body 21, $h_c$ is the iron core height of the magnetic circuit component main body 21, $h_t$ is the height of the gear tooth, and $H_1$ is the first magnetic field intensity;

Referring to FIG. 2, in the related technology, the parameters of the fault point loop in the iron loss method test have the following relationships:

$$\begin{cases} S_2 = U_2 * I_2 \\ U_2 = 4.44 * f_2 * l_u * h_y * B_2 \\ I_2 = \pi * \left( D_1 - h_y \right) * H_2 \end{cases} \quad (2);$$

wherein, $S_2$ is the second excitation power, $U_2$ is the second excitation voltage, $f_2$ is the second frequency, $l_u$ is the effective length of the iron core, $h_y$ is the height of the iron core yoke part, $B_2$ is the second magnetic induction intensity, $I_2$ is the second excitation current, $D_1$ is the outer diameter of the iron core, and $H_2$ is the second magnetic field intensity.

When the frequency, magnetic induction intensity and magnetic field intensity of the two are the same (that is $f_1 = f_2$, $B_1 = B_2$, $H_1 = H_2$), it can be known from formulas (1) and (2) that the power ratio of the power supply between the method of the present invention and the iron loss method is:

$$\frac{2\left(l_c+h_c+h_t+\frac{1}{2}h_y\right)w_t l_t}{\pi(D_1-h_y)l_u h_y} \quad (3);$$

In some embodiments, taking a certain model as an example, $D_1$ is 2.99 m, the height of the yoke $h_y$ is 0.525 m, $l_u$ is 6.4 m, $h_t$ is 0.215 m, $l_c$ is 0.232 m, $h_c$ is 0.1 m, $w_t$ is 0.058 m, and $l_t$ is 0.1 m. By substituting these values into formula (3), it can be obtained that the power ratio of the power supply between the method of the present invention and the iron loss method is 0.00032. In this embodiment, compared with the iron loss method, the present invention can reduce the power of the test power supply by as much as 3,125 times.

In addition, in this embodiment, since the excitation winding 22 and the fault point loop form an electrical structure similar to a transformer, the input voltage and input current of the excitation winding 22 have the following relationships:

$$\begin{cases} U_3 = N * U_1 \\ I_3 = I_1/N \end{cases} \quad (4);$$

Wherein, $U_3$ is the input voltage of the exciting winding 22, N is the number of turns of the exciting winding 22, and $I_3$ is the input current of the exciting winding 22.

It can be seen from formula (4) that under the condition that the exciting voltage and the exciting current are at stable values, the input voltage $U_3$ of the exciting winding 22 is in a direct proportional relationship with the number of turns N, and the input current $I_3$ of the exciting winding 22 is also in a direct proportional relationship with the number of turns N. Therefore, during the test, the number of turns can be adjusted according to the output voltage and current of the test power supply. For example, the higher the output voltage of the test power supply is, the more the number of turns will be.

Step S2 includes: performing excitation processing on the test magnetic circuit, to make the test magnetic circuit enter a predetermined saturated state for a preset duration. wherein, the role of the excitation processing is to make the magnetic circuit where the suspected fault point is located enter a predetermined saturated state similar to that during the iron loss method test, that is, the magnetic induction intensity of the magnetic circuit reaches 1.4T, and the induced voltage generated at the fault point is consistent with the induced voltage generated during the iron loss method test, so that the heat generated at the fault point is the same as that during the iron loss method test.

In some embodiments, step S2 includes: collecting the induced voltage of the suspected fault point, and by adjusting the input voltage of the exciting winding 22 with a preset frequency, making the induced voltage of the suspected fault point be adjusted to be equal to the predetermined saturated voltage of the test magnetic circuit, and maintaining it for a preset duration.

In some embodiments, the preset magnetic circuit component 2 also includes a measuring coil 23 for measuring the induced voltage, and the measuring coil 23 can be arranged on the second side column 213. Correspondingly, collecting the induced voltage of the suspected fault point in step S2 includes: collecting the measured voltage of the measuring coil 23, and calculating the induced voltage of the suspected fault point according to the number of turns of the measuring coil 23 and the measured voltage. In some embodiments, a voltmeter can be connected to both ends of the measuring coil 23 to collect the measured voltage.

Since the fault point loop is equivalent to a coil with the number of turns being 1 and is wound on the same test magnetic circuit as the test coil, the expression for the induced voltage in step S2 is as follows:

$$U_s = U_t/N_2 (4) \ ,$$

wherein, $U_s$ is the induced voltage, $U_t$ is the measured voltage, and $N_2$ is the number of turns of the measuring coil 23.

Similarly, since the fault point loop is equivalent to a coil with the number of turns being 1, when the test magnetic circuit enters the predetermined saturated state, according to the calculation formula for magnetic flux intensity: B = U/(4.44 * f * N * S) can be derived, and the expression for the predetermined saturated voltage is:

$$U_b = B_b * (4.44 * f_b * S_t) \quad (5);$$

wherein $U_b$ is the predetermined saturated voltage, $B_b$ is the preset saturated magnetic induction intensity of the test magnetic circuit (generally taken as 1.4T), 4.44 is the induced electromotive force coefficient, $f_b$ is the preset frequency, and $S_t$ is the contact area between the main body 21 of the magnetic circuit component and the gear teeth.

According to the relevant information of the iron loss method, it can be known that during the test, the fault point loop at the iron core fault point has the following relationship:

$$I_{ff} = \frac{U_{ff}}{R} = \frac{4.44 * f_3 * B_3 * S_y}{R} \quad (6);$$

wherein, $I_{ff}$ is the fault current during the iron loss test, $U_{ff}$ is the induced voltage of the fault point during the iron loss test, R is the resistance of the fault point loop, $f_3$ is the third frequency, $B_3$ is the third magnetic induction intensity (generally taken as 1.4T), and $S_y$ is the yoke area of the iron core (that is, the effective cross-sectional area of the magnetic circuit).

It can be obtained from formula (6) that the expression for the induced voltage of the fault point during the iron loss test is: $U_{ff}$ = 4.44 * $f_{ff}$ * $B_3$ * $S_y$ (7). In order to ensure that the induced voltage of the test magnetic circuit when it enters the predetermined saturated state is consistent with the induced voltage in the iron loss method, that is, to satisfy $U_b$ equals $U_{ff}$, it can be known from formula (5) and formula (7) that it is necessary to make $f_b * S_t$ equal to $f_{ff} * S_y$. Since the measurement frequency of the iron loss method is generally taken as 50 Hz, therefore, the preset frequency can be set according to the following expression: $f_b = 50 * S_y/S_t$, where $S_y$ is the cross-sectional area of the yoke.

It can be known from formula (2) that when $B_b$, f and $S_t$ are all definite values, the theoretical definite value of $U_b$ can be obtained. Understandably, the corresponding control equipment can collect the measured voltage and calculate the induced voltage based on the expression of the induced voltage. The control equipment adjusts the magnitude of the input voltage of the exciting winding 22 to control the induced voltage $U_s$. When the induced voltage $U_s$ is equal to $U_b$, it indicates that the test magnetic circuit has entered the predetermined saturated state. Then the control equipment will stop adjusting the input voltage of the exciting winding 22, and step S3 can be executed after maintaining it for the preset time.

Step S3 includes: collecting thermal imaging information of the test magnetic circuit, and generating a fault determination result according to the thermal imaging information.

In some embodiments, generating the fault determination result according to the thermal imaging information in step S3 includes: extracting the temperature features from the thermal imaging information, determining whether there is an area in the generator iron core part of the test magnetic circuit where the temperature is higher than the fault temperature. If there is an area with a temperature higher than the fault temperature, it indicates that there is a fault in this area, which leads to an increase in its internal resistance, making the heat generation in this area greater than that in other normal areas, and then it can be judged that there is a fault point in this area. If there is no area with a temperature higher than the fault temperature, it indicates that the heat generation in the generator iron core part of the test magnetic circuit is uniform, and then it can be judged that there is no fault point in the generator iron core.

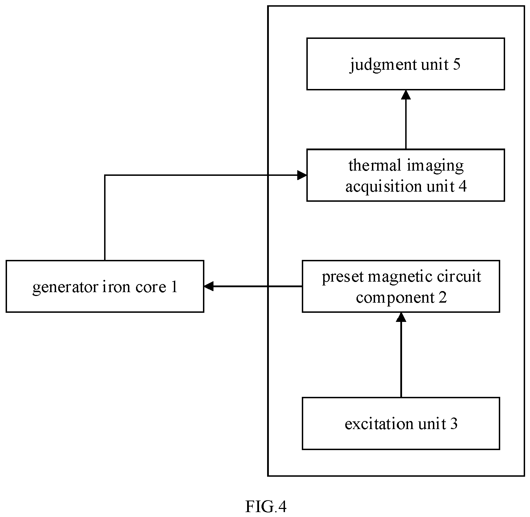

Referring to FIG. 4, the present invention also provides a generator iron core fault detection system for determining whether the suspected fault points of the generator iron core 1 have faults. The generator iron core fault detection system includes a preset magnetic circuit component 2, an excitation unit 3, a thermal imaging acquisition unit 4 and a judgment unit 5.

The preset magnetic circuit component 2 is used for building a test magnetic circuit.

The excitation unit 3 is used for performing excitation processing on the built test magnetic circuit to make the test magnetic circuit enter a predetermined saturated state for a preset duration.

The thermal imaging acquisition unit 4 is used for collecting the thermal imaging information of the test magnetic circuit.

The judgment unit 5 is used for generating a fault determination result according to the thermal imaging information.

In some embodiments, as shown in FIG. 2, the preset magnetic circuit component 2 includes a magnetic circuit component main body 21, an exciting winding and a measuring coil. The two contact surfaces of the magnetic circuit component main body 21 are used for being attached and connected to the surfaces of the gear teeth on both sides of the suspected fault point. The exciting winding 22 and the measuring coil 23 are respectively arranged on the magnetic circuit component main body 21. The exciting winding 22 is used for providing magnetic field energy for the test magnetic circuit, and the measuring coil 23 is used for collecting the induced voltage of the suspected fault point.

In some embodiments, the excitation unit 3 includes a high-frequency power supply, a voltage collector and an excitation control unit.

The high-frequency power supply is used for providing an input voltage for the exciting winding 22.

The voltage collector is used for measuring the measured voltage of the measuring coil 23. Further, the voltage collector can be a voltmeter.

The excitation control unit is used for controlling the output voltage of the high-frequency power supply according to the measured voltage, so as to make the test magnetic circuit enter a predetermined saturated state and maintain it for a preset duration.

The present invention has at least the following beneficial effects: a generator iron core fault detection method is provided. Firstly, performing local magnetic circuit setting on a suspected fault point, and building a test magnetic circuit. Then, performing excitation processing on the test magnetic circuit, the excitation processing can use a low-power power supply and can also make the test magnetic circuit enter a predetermined saturated state for a preset duration, collecting thermal imaging information of the test magnetic circuit. Finally generating a fault determination result according to the thermal imaging information. Compared with a conventional iron loss method, implementing the present invention can greatly reduce the power required by a test power supply, which can be easily met in a nuclear power plant, without the need to transport a large quantity of heavy test devices. Moreover, the method is simple and efficient, whether an iron core has a fault point can be accurately determined, and the iron loss test duration, workload and cost are effectively reduced.

It should be understood that the above embodiments only represent the preferred implementation modes of the present invention. Although the descriptions are relatively specific and detailed, they should not be construed as limiting the scope of the patent of the present invention. It should be noted that, for ordinary technicians in the relevant field, on the premise of not departing from the concept of the present invention, they can freely combine the above technical features, and can also make several modifications and improvements, all of which fall within the protection scope of the present invention. Therefore, all equivalent transformations and modifications made within the scope of the claims of the present invention shall fall within the coverage scope of the claims of the present invention.

**Claims**

1. A generator iron core fault detection method, for determining whether there is a fault at suspected fault points of the generator iron core, wherein comprising the following steps;

   S1. performing local magnetic circuit setting on a suspected fault point, and building a test magnetic circuit;
   S2. performing excitation processing on the test magnetic circuit, to make the test magnetic circuit enter a predetermined saturated state for a preset duration;
   S3. collecting thermal imaging information of the test magnetic circuit, and generating a fault determination result according to the thermal imaging information.

2. The generator iron core fault detection method according to claim 1, wherein, in S1, performing local magnetic circuit setting on a suspected fault point comprising: making the gear teeth on the two adjacent sides of the suspected fault point communicate through a preset magnetic circuit component.

3. The generator iron core fault detection method according to claim 2, wherein the preset magnetic circuit component includes a magnetic circuit component main body and an excitation winding arranged on the magnetic circuit component main body and used for providing magnetic field energy for the test magnetic circuit; the two contact surfaces of the magnetic circuit component main body are respectively attached to the surfaces of the teeth on both sides of the suspected fault point.

4. The generator iron core fault detection method according to claim 3, wherein, the magnetic circuit component main body includes a crossbeam, as well as a first side column and a second side column extending outward from the two ends of the crossbeam; the effective cross-sectional areas of the crossbeam, the first side column and the second side column are not less than the tooth tip area of the gear tooth.

5. The generator iron core fault detection method according to claim 3, wherein, S2 includes: collecting the induced voltage of the suspected fault point, and by adjusting the input voltage of the excitation winding with a preset frequency, making the induced voltage of the suspected fault point adjusted to be equal to the predetermined saturated voltage of the test magnetic circuit and maintaining it for a preset duration.

6. The generator iron core fault detection method according to claim 5, wherein, the preset magnetic circuit component further includes a measuring coil used for measuring the induced voltage;

   correspondingly, in S2, collecting the induced voltage of the suspected fault point comprising: collecting the measured voltage of the measuring coil, and calculating the induced voltage of the suspected fault point according to the number of turns of the measuring coil and the measured voltage;
   the expression for the induced voltage is: $U_s = U_t/N_2$
   wherein, $U_s$ is the induced voltage, $U_t$ is the measured voltage, and $N_2$ is the number of turns of the measuring coil.

7. The generator iron core fault detection method according to claim 6, wherein, in S2, the expression for the predetermined saturated voltage is:

$$U_b = B_b * (4.44 * f_b * S_t);$$

wherein, $U_b$ is the predetermined saturated voltage, $B_b$ is the preset saturated magnetic induction intensity of the test magnetic circuit, $f_b$ is the preset frequency, and $S_t$ is the contact area between the magnetic circuit component main body and the gear tooth.

8. The generator iron core fault detection method according to any one of claims 1 to 7, wherein, in S3, generating a fault determination result according to the thermal imaging information comprising: extracting temperature features from the thermal imaging information, judging whether there is an area in the generator iron core part of the test magnetic circuit where the temperature is higher than the fault temperature, and if so, determining that there is a fault point in the generator iron core, otherwise determining that there is no fault point in the generator iron core.

9. A generator iron core fault detection system, for determining whether a fault is present at the suspected fault point of a generator iron core, wherein, comprising:

a preset magnetic circuit component, which is used for building a test magnetic circuit;

an excitation unit, which is used for performing excitation processing on the built test magnetic circuit, and making the test magnetic circuit enter a predetermined saturated state for a preset duration;

a thermal imaging acquisition unit, which is used for collecting the thermal imaging information of the test magnetic circuit.

a judgment unit, which is used for generating a fault determination result according to the thermal imaging information.

10. A generator iron core fault detection system according to claim 9, wherein the excitation unit includes:

a high-frequency power supply, which is used for providing an input voltage for the excitation winding;

a voltage collector, which is used for measuring the measured voltage of the measuring coil;

an excitation control unit, which is used for controlling the output voltage of the high-frequency power supply according to the measured voltage, so as to make the test magnetic circuit enter a predetermined saturated state and maintain it for a preset duration.

```
                    ┌──────────────────┐
                    │     Starting     │
                    └──────────────────┘
                             │
                             ▼                                    S1
    ┌───────────────────────────────────────────────────────┐
    │  Performing local magnetic circuit setting on a        │
    │  suspected fault point, and building a test            │
    │  magnetic circuit;                                     │
    └───────────────────────────────────────────────────────┘
                             │
                             ▼                                    S2
    ┌───────────────────────────────────────────────────────┐
    │  Performing excitation processing on the test          │
    │  magnetic circuit, to make the test magnetic circuit   │
    │  enter a predetermined saturated state for a preset    │
    │  duration;                                             │
    └───────────────────────────────────────────────────────┘
                             │
                             ▼                                    S3
    ┌───────────────────────────────────────────────────────┐
    │  Collecting thermal imaging information of the test    │
    │  magnetic circuit, and generating a fault              │
    │  determination result according to the thermal         │
    │  imaging information.                                  │
    └───────────────────────────────────────────────────────┘
                             │
                             ▼
                    ┌──────────────────┐
                    │       End        │
                    └──────────────────┘
```

FIG.1

FIG.2

FIG.3

FIG.4

<div align="center">

**INTERNATIONAL SEARCH REPORT**

</div>

| | International application No. |
|---|---|
| | **PCT/CN2022/122323** |

**A. CLASSIFICATION OF SUBJECT MATTER**

G01R31/34(2020.01)i;G01R19/00(2006.01)i;G01J5/48(2022.01)i

According to International Patent Classification (IPC) or to both national classification and IPC

**B. FIELDS SEARCHED**

Minimum documentation searched (classification system followed by classification symbols)

    G01R; G01J

Documentation searched other than minimum documentation to the extent that such documents are included in the fields searched

Electronic data base consulted during the international search (name of data base and, where practicable, search terms used)

    CJFD, CNTXT, ENTXTC, CNKI, IEEE: 电机, 马达, 电动机, 芯, 故障, 缺陷, 短路, 检测, 探测, 磁轭, 磁路, 红外, 热, 像, motor, machine, core, fault, flaw, defect, detect, yoke, path, infrared, IR, thermal, image

**C. DOCUMENTS CONSIDERED TO BE RELEVANT**

| Category* | Citation of document, with indication, where appropriate, of the relevant passages | Relevant to claim No. |
|---|---|---|
| X | CN 106404900 A (CHINA JILIANG UNIVERSITY) 15 February 2017 (2017-02-15) description, paragraphs 0013 and 0018, and figure 1 | 1-4, 8, 9 |
| Y | CN 106404900 A (CHINA JILIANG UNIVERSITY) 15 February 2017 (2017-02-15) description, paragraphs 0013 and 0018, and figure 1 | 5-7, 10 |
| Y | 胡国立 等 (HU, Guoli et al.). ""电动机定子铁损实验的探讨" (Non-official translation: Discussion on Iron Loss Test of Motor Stator)" 甘肃科技纵横 (*Scientific & Technical Information of Gansu*), Vol. 46, No. 2, 25 February 2017 (2017-02-25), text, sections 1-8, and figure 1 | 5-7, 10 |
| X | CN 109324085 A (SICHUAN MUDISHENG TECHNOLOGY CO., LTD.) 12 February 2019 (2019-02-12) description, paragraphs 0036-0053, and figure 5 | 1-4, 8, 9 |
| Y | CN 109324085 A (SICHUAN MUDISHENG TECHNOLOGY CO., LTD.) 12 February 2019 (2019-02-12) description, paragraphs 0036-0053, and figure 5 | 5-7, 10 |

☑ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **16 April 2023** | **20 April 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2022/122323** |

**C.    DOCUMENTS CONSIDERED TO BE RELEVANT**

| Category* | Citation of document, with indication, where appropriate, of the relevant passages | Relevant to claim No. |
| --- | --- | --- |
| Y | CN 207780118 U (LEROY SOMER ELECTRO-TECHNIQUE (FUZHOU) CO., LTD.) 28 August 2018 (2018-08-28)<br>description, paragraphs 0040-0042, and figure 1 | 5-7, 10 |
| A | CN 103430017 A (SIEMENS ENERGY, INC.) 04 December 2013 (2013-12-04)<br>entire document | 1-10 |
| A | CN 1759325 A (SIEMENS AG) 12 April 2006 (2006-04-12)<br>entire document | 1-10 |
| A | DE 102020106482 B3 (EDEVIS GMBH) 26 August 2021 (2021-08-26)<br>entire document | 1-10 |
| A | US 6489781 B1 (GENERAL ELECTRIC COMPANY) 03 December 2002 (2002-12-03)<br>entire document | 1-10 |

Form PCT/ISA/210 (second sheet) (July 2022)

**INTERNATIONAL SEARCH REPORT**
Information on patent family members

International application No.

**PCT/CN2022/122323**

| Patent document cited in search report | | | Publication date (day/month/year) | Patent family member(s) | | | Publication date (day/month/year) |
|---|---|---|---|---|---|---|---|
| CN | 106404900 | A | 15 February 2017 | None | | | |
| CN | 109324085 | A | 12 February 2019 | None | | | |
| CN | 207780118 | U | 28 August 2018 | None | | | |
| CN | 103430017 | A | 04 December 2013 | CA | 2826162 | A1 | 29 November 2012 |
| | | | | EP | 2673629 | A1 | 18 December 2013 |
| | | | | KR | 20130118392 | A | 29 October 2013 |
| | | | | KR | 101532555 | B1 | 01 July 2015 |
| | | | | US | 2012206162 | A1 | 16 August 2012 |
| | | | | US | 8508220 | B2 | 13 August 2013 |
| | | | | JP | 2014507659 | A | 27 March 2014 |
| | | | | WO | 2012161760 | A1 | 29 November 2012 |
| CN | 1759325 | A | 12 April 2006 | ES | 2294345 | T3 | 01 April 2008 |
| | | | | EP | 1601985 | A1 | 07 December 2005 |
| | | | | EP | 1601985 | B1 | 28 November 2007 |
| | | | | AU | 2003294660 | A1 | 30 September 2004 |
| | | | | WO | 2004081594 | A1 | 23 September 2004 |
| | | | | US | 2006219921 | A1 | 05 October 2006 |
| | | | | US | 7605592 | B2 | 20 October 2009 |
| | | | | DE | 50308709 | D1 | 10 January 2008 |
| DE | 102020106482 | B3 | 26 August 2021 | None | | | |
| US | 6489781 | B1 | 03 December 2002 | US | 2002186023 | A1 | 12 December 2002 |

Form PCT/ISA/210 (patent family annex) (July 2022)